(19) Europäisches Patentamt
European Patent Office
Office européen des brevets

(11) EP 2 273 476 A1

(12) EUROPEAN PATENT APPLICATION
published in accordance with Art. 153(4) EPC

(43) Date of publication:
**12.01.2011 Bulletin 2011/02**

(21) Application number: **09734244.8**

(22) Date of filing: **17.04.2009**

(51) Int Cl.:
***G09F 9/30*** *(2006.01)* ***B32B 17/10*** *(2006.01)*
***G02F 1/1333*** *(2006.01)* ***H01L 51/50*** *(2006.01)*
***H05B 33/02*** *(2006.01)* ***H05B 33/10*** *(2006.01)*

(86) International application number:
**PCT/JP2009/057785**

(87) International publication number:
**WO 2009/131073 (29.10.2009 Gazette 2009/44)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **24.04.2008 JP 2008114373**
**24.04.2008 JP 2008114374**
**07.11.2008 JP 2008286164**

(71) Applicant: **Nitto Denko Corporation**
**Ibaraki-shi**
**Osaka 567-8680 (JP)**

(72) Inventors:
- **MURASHIGE, Takeshi**
**Ibaraki-shi**
**Osaka 567-8680 (JP)**
- **HATTORI, Daisuke**
**Ibaraki-shi**
**Osaka 567-8680 (JP)**
- **SAKATA, Yoshimasa**
**Ibaraki-shi**
**Osaka 567-8680 (JP)**
- **YAMAOKA, Takashi**
**Ibaraki-shi**
**Osaka 567-8680 (JP)**
- **NAGATSUKA, Tatsuki**
**Ibaraki-shi**
**Osaka 567-8680 (JP)**

(74) Representative: **HOFFMANN EITLE**
**Patent- und Rechtsanwälte**
**Arabellastraße 4**
**81925 München (DE)**

# (54) TRANSPARENT SUBSTRATE

(57) There is provided a transparent substrate which is excellent in dimensional stability, which significantly prevents the progress of a crack in an inorganic glass and the rupture of the inorganic glass, and which is excellent in flexibility. A transparent substrate according to an embodiment of the present invention includes: an inorganic glass having a thickness of 10 μm to 100 μm; and a resin layer on one side, or each of both sides, of the inorganic glass, wherein: a ratio of a total thickness of the resin layer to a thickness of the inorganic glass is 0.9 to 4; the resin layer has a modulus of elasticity at 25°C of 1.5 GPa to 10 GPa; and the resin layer has a fracture toughness value at 25°C of 1.5 MPa·m$^{1/2}$ to 1C MPa·m$^{1/2}$.

Fig.1(a)

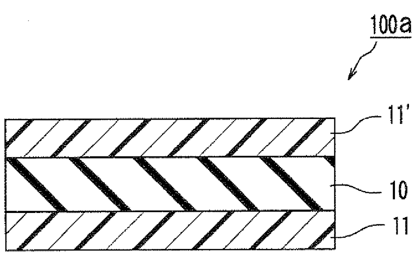


EP 2 273 476 A1

Fig.1(b)

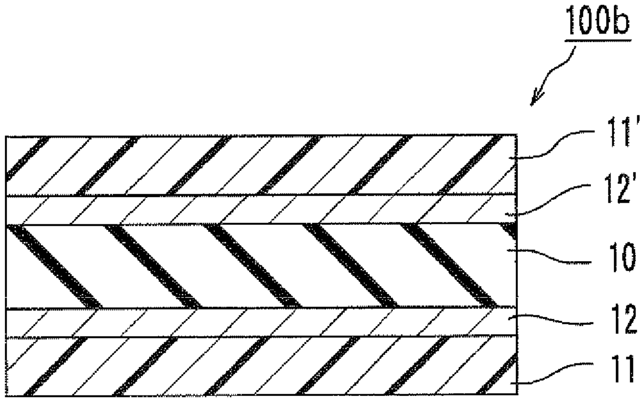

## Description

### Technical Field

The present invention relates to a transparent substrate, and more specifically, to a transparent substrate which is excellent in dimensional stability, which significantly prevents the progress of a crack in an inorganic glass, and which is excellent in flexibility.

### Background Art

In recent years, the weight reductions and thinning of display devices like flat panel displays (FPDs: liquid crystal display devices, organic EL display devices, and the like) and solar cells have been progressing from the viewpoints of, for example, conveying property, storing property, and design, and an improvement in flexibility has also been requested. Glass substrates have been conventionally used as transparent substrates for use in the display devices and the solar cells in many cases. The glass substrates are each excellent in transparency, solvent resistance, gas barrier properties, and heat resistance. However, when one attempts to achieve the weight reduction and thinning of a glass material of which any such glass substrate is formed, the following problem arises. That is, the glass substrate shows some degree of, but not sufficient, flexibility and insufficient impact resistance, and hence the glass substrate becomes difficult to handle.

In order that the handleability of thin glass substrates may be improved, substrates in each of which a resin layer is formed on a glass surface have been disclosed (see, for examples, Patent Documents 1 and 2). However, no transparent substrates each showing sufficient dimensional stability and sufficient flexibility has been obtained yet even with those technologies.

### Prior Art Documents

Patent Documents
[Patent Document 1] JP 11-329715 A
[Patent Document 2] JP 2008-107510 A

### Summary of the Invention

### Problem to be solved by the Invention

The present invention has been made to solve the above-mentioned conventional problems, and an obj ect of the present invention is to provide a transparent substrate which is excellent in dimensional stability, which significantly prevents the progress of a crack in an inorganic glass and the rupture of the inorganic glass, and which is excellent in flexibility.

### Means for solving the Problems

A transparent substrate according to an embodiment of the present invention includes: an inorganic glass having a thickness of 10 μm to 100 μm; and a resin layer on one side, or each of both sides, of the inorganic glass, wherein: a ratio of a total thickness of the resin layer to a thickness of the inorganic glass is 0.9 to 4; the resin layer has a modulus of elasticity at 25°C of 1.5 GPa to 10 GPa: and the resin layer has a fracture toughness value at 25°C of 1.5 $MPa{\cdot}m^{1/2}$ to 10 $MPa{\cdot}m^{1/2}$.
In a preferred embodiment of the invention, the resin layer contains a resin, and the resin has a glass transition temperature of 150°C to 350°C.
In a preferred embodiment of the invention, the resin layer is obtained by applying a solution of a thermoplastic resin to a surface of the inorganic glass.
In a preferred embodiment of the invention, the transparent substrate further includes a coupling agent layer on the inorganic glass.
In a preferred embodiment of the invention, the coupling agent layer includes a coupling agent layer obtained by curing an amino group-containing coupling agent, an epoxy group-containing coupling agent, or an isocyanate group-containing coupling agent, and the resin layer contains a thermoplastic resin containing an ester bond.
In a preferred embodiment of the invention, the coupling agent layer includes a coupling agent layer obtained by curing

an epoxy group-terminated coupling agent, and the resin layer contains a thermoplastic resin having a hydroxyl group at any one of its terminals.

In a preferred embodiment of the invention, the inorganic glass and the resin layer are placed through an adhesion layer, and the adhesion layer has a thickness of 10 μm or less.

In a preferred embodiment of the invention, the coupling agent layer and the resin layer are placed through an adhesion layer, and the adhesion layer has a thickness of 10 μm or less.

In a preferred embodiment of the invention, the transparent substrate has a total thickness of 150 μm or less.

In a preferred embodiment of the invention, the transparent substrate is used as a substrate for a display device or solar cell.

According to another aspect of the present invention, a display device is provided. The display device includes the transparent substrate as described above.

According to another aspect of the present invention, a solar cell is provided. The solar cell includes the transparent substrate as described above.

Effects of the Invention

According to the present invention, there can be provided a transparent substrate which is excellent in dimensional stability, which significantly prevents the progress of a crack in an inorganic glass and the rupture of the inorganic glass, and which is excellent in flexibility by providing one side, or each of both sides, of the inorganic glass with a resin layer having a specific modulus of elasticity and a specific fracture toughness value at a specific thickness ratio with respect to the inorganic glass.

Brief Description of the Drawings

[FIGS. **1**] FIG. **1(a)** is a schematic sectional view of a transparent substrate according to a preferred embodiment of the present invention and FIG. **1(b)** is a schematic sectional view of a transparent substrate according to another preferred embodiment of the present invention.

[FIGS. **2**] FIG. **2(a)** is a schematic sectional view of a transparent substrate according to still another embodiment of the present invention and FIG. **2(b)** is a schematic sectional view of a transparent substrate according to still another preferred embodiment of the present invention.

List of Reference Numerals

| | |
|---|---|
| **10** | inorganic glass |
| **11, 11'** | resin layer |
| **12, 12'** | coupling agent layer |
| **13, 13'** | adhesion layer |
| **100a, 100b** | transparent substrate |

Description of Embodiments

A. Entire configuration of transparent substrate

FIG. **1(a)** is a schematic sectional view of a transparent substrate according to a preferred embodiment of the present invention. The transparent substrate **100a** includes an inorganic glass **10** and a resin layer **11** or **11'** placed on one side, or each of both sides, of the inorganic glass **10** (preferably on each of both sides like the illustrated example). FIG. **1(b)** is a schematic sectional view of a transparent substrate according to another preferred embodiment of the present invention. The transparent substrate **100b** further includes a coupling agent layer **12** or **12'** between the inorganic glass **10** and the resin layer **11** or **11'.** FIG. **2(a)** is a schematic sectional view of a transparent substrate according to still another preferred embodiment of the present invention. The transparent substrate **100c** further includes an adhesion layer **13** or **13'** between the inorganic glass **10** and the resin layer **11** or **11'.** FIG. **2(b)** is a schematic sectional view of a transparent substrate according to still another preferred embodiment of the present invention. The transparent substrate **100d** further includes the coupling agent layer **12** or **12'** and the adhesion layer **13** or **13'** between the inorganic glass **10** and the resin layer. Although not illustrated, any one of the above-mentioned transparent substrates can include any appropriate other layer on the side of the above-mentioned resin layer opposite to the abode-mentioned inorganic glass as required. Examples of the above-mentioned other layer include a transparent conductive layer and a hard coat

layer.

In the transparent substrate of the present invention, the above-mentioned inorganic glass and the above-mentioned resin layer may be placed through the above-mentioned coupling agent layer (inorganic glass /coupling agent layer/resin layer) as illustrated in FIG. **1(b),** or the inorganic glass and the resin layer may be placed through the adhesion layer (inorganic glass/adhesion layer/resin layer) as illustrated in FIG. **2(a).** In addition, the transparent substrate of the present invention may be as described below. That is, as illustrated in FIG. **2(b),** the transparent substrate has the above-mentioned coupling agent layer and adhesion layer, and the inorganic glass, the coupling agent layer, the adhesion layer, and the resin layer are placed in the stated order. It is preferred that the above-mentioned coupling agent layer be directly formed on the above-mentioned inorganic glass It is more preferred that the above-mentioned inorganic glass and the above-mentioned resin layer be placed only through the above-mentioned coupling agent layer (inorganic glass/ coupling agent layer/resin layer). With such configuration, the above-mentioned inorganic glass and the above-mentioned resin layer can be caused to adhere to each other strongly, and hence a transparent substrate which is excellent in dimensional stability and in which a crack hardly progresses can be obtained.

It is preferred that the above-mentioned coupling agent layer be chemically bonded (typically, covalently bonded) to the above-mentioned inorganic glass. As a result, a transparent substrate excellent in adhesiveness between the above-mentioned inorganic glass and the above-mentioned coupling agent layer can be obtained.

It is preferred that the above-mentioned resin layer or adhesion layer be bonded to the above-mentioned coupling agent layer with a chemical bond (typically, a covalent bond), or interact with the coupling agent layer. As a result, a transparent substrate excellent in adhesiveness between the above-mentioned coupling agent layer and the above-mentioned resin layer or adhesion layer can be obtained.

The above-mentioned transparent substrate has a total thickness of preferably 150 μm or less, more preferably 140 μm or less, and particularly preferably 80 μm to 130 μm. According to the present invention, the thickness of the inorganic glass can be made much smaller than that of a conventional glass substrate by virtue of the presence of the resin layer as described above. That is, the above-mentioned resin layer can contribute to improvements in impact resistance and toughness even when the resin layer is thin. Accordingly, the transparent substra te of the present invention having the resin layer has a light weight, a small thickness, and excellent impact resistance. The thicknesses of the inorganic glass and the resin layer are described later.

The rupture diameter of the above-mentioned transparent substrate when cracked and curved is preferably 50 mm or less, and more preferably 40 mm or less.

The light transmittance of the above-mentioned transparent substrate at a wavelength of 550 nm is preferably 80% or more, and more preferably 85% or more. The reduction ratio of light transmittance of the above-mentioned transparent substrate after the heat treatment at 180°C for 2 hours is preferably within 5%. This is because, with such reduction ratio, the practically acceptable light transmittance can be kept, even if a heat treatment required in a production process of display devices and solar cells is conducted.

A surface roughness Ra of the above-mentioned transparent substrate (substantially, a surface roughness Ra of the above-mentioned resin layer or the above-mentioned other layer) is preferably 50 nm or less, more preferably 30 nm or less, and particularly preferably 10 nm or less. The wave of the above-mentioned transparent substrate is preferably 0.5 μm or less, and more preferably 0.1 μm or less. The transparent substrate with such characteristics is excellent in quality. Such characteristics can be realized, for example, by a production method described later.

The above-mentioned transparent substrate has a coefficient of linear expansion of preferably 15 ppm/°C or less, more preferably 10 ppm/°C or less, and particularly preferably 1 ppm/°C to 10 ppm/°C. The above-mentioned transparent substrate shows excellent dimensional stability (e.g., a coefficient of linear expansion within such a range as described above) because the transparent substrate has the above-mentioned inorganic glass. To be additionally specific, the above-mentioned inorganic glass itself is stiff, and fluctuations in dimensions of the above-mentioned resin layer can be suppressed because the resin layer is restrained by the inorganic glass. As a result, the entirety of the above-mentioned transparent substrate shows excellent dimensional stability.

B. Inorganic glass

As the inorganic glass used in the transparent substrate of the present invention, any appropriate glass can be adopted as long as the glass is in a plate shape. Examples of the above-mentioned inorganic glass include soda-lime glass, borate glass, aluminosilicate glass, and quartz glass according to the classification based on a composition. Further, according to the classification based on an alkali component, no-alkali glass and low alkali glass are exemplified. The content of an alkali metal component (e.g., $Na_2O$ $K_2O$, $Li_2O$) of the above-mentioned inorganic glass is preferably 15 wt% or less, and more preferably 10 wt% or less.

The thickness of the above-mentioned inorganic glass is preferably 80 μm or less, more preferably 20 μm to 80 μm, and particularly preferably 30 μm to 70 μm. In the present invention, even if the thickness of the inorganic glass is reduced, a transparent glass which is excellent in impact resistance can be obtained by providing a resin layer on one

side, or each of both sides, of the inorganic glass.

The transmittance of the above-mentioned inorganic glass at a wavelength of 550 nm is preferably 85% or more. A refractive index of the above-mentioned inorganic glass at a wavelength of 550 nm is preferably 1.4 to 1.65.

The density of the above-mentioned inorganic glass is preferably 2.3 g/cm$^3$ to 3.0 g/cm$^3$, and more preferably 2.3 g/cm$^3$ to 2.7 g/cm$^3$. With the inorganic glass in the above-mentioned range, a light-weight transparent substrate is obtained.

As a method of forming the above-mentioned inorganic glass, any appropriate method can be adopted. Typically, the above-mentioned inorganic glass is produced by melting a mixture containing a main material such as silica and alumina, an antifoaming agent such as salt cake and antimony oxide, and a reducing agent such as carbon at a temperature of 1400°C to 1600°C to form a thin plate, followed by cooling. Examples of the method of forming a thin plate of the above-mentioned inorganic glass include a slot down draw method, a fusion method, and a float method. The inorganic glass formed into a plate shape by those methods may be chemically polished with a solvent such as hydrofluoric acid, if required, in order to reduce the thickness and enhance smoothness.

As the above-mentioned inorganic glass, commercially available inorganic glass may be used as it is, or commercially available inorganic glass may be polished so as to have a desired thickness. Examples of the commercially available inorganic glass include "7059, " "1737, or "EAGLE 2000" each manufactured by Corning Incorporated, "AN100" manufactured by Asahi Glass Co. , Ltd., "NA-35" manufactured by NH Technoglass Corporation, "OA-10" manufactured by Nippon Electric Glass Co., Ltd., and "D263" or "AF45" each manufactured by SCHOTT AG.

C. Resin layer

The thickness of the resin layer is preferably 5 μm to 100 μm, more preferably 10 μm to 80 μm, and particularly preferably 15 μm to 60 μm. When the above-mentioned resin layers are placed on both sides of the above-mentioned inorganic glass, the thickness of respective resin layers may be identical to or different from each other. The thickness of respective resin layers is preferably identical to each other. Further, respective resin layers may be formed of the same resin or a resin having the same characteristics, or may be formed of different resins. Respective resin layers are preferably formed of the same resin. Thus, respective resin layers are most preferably formed of the same resin with the same thickness. With such configuration, a warping or wave occurs can be extremely suppressed because thermal stresses are uniformly applied to both surfaces of the inorganic glass even when a heat treatment is performed.

A ratio of the total thickness of the above-mentioned resin layer to the thickness of the above-mentioned inorganic glass is 0.9 to 4, preferably 0.9 to 3, and more preferably 0.9 to 2.2. As long as the ratio of the total thickness of the above-mentioned resin layer falls within such range, a transparent substrate excellent in flexibility and dimensional stability can be obtained. It should be noted that, when the transparent substrate of the present invention has resin layers on both sides of the above-mentioned inorganic glass, the term "total thickness of the resin layer" as used herein refers to the sum of the thicknesses of the respective resin layers.

The above-mentioned resin layer has a modulus of elasticity at 25°C of 1.5 GPa to 10 GPa, preferably 1.7 GPa to 8 GPa, and more preferably 1.9 GPa to 6 GPa. As long as the modulus of elasticity of the above-mentioned resin layer falls within such range, even when the inorganic glass is made thin, the resin layer alleviates a local stress in the direction in which the inorganic glass is torn toward a defect at the time of the deformation. Accordingly, the inorganic glass hardly cracks or ruptures.

The above-mentioned resin layer has a fracture toughness value at 25°C of 1.5 MPa·m$^{1/2}$ to 10 MPa·m$^{1/2}$, preferably 2 MPa·m$^{1/2}$ to 6 MPa·m$^{1/2}$, and more preferably 2 MPa·m$^{1/2}$ to 5 MPa·m$^{1/2}$. As long as the fracture toughness value of the above-mentioned resin layer falls within such range, the resin layer has sufficient toughness, and hence a transparent substrate in which the above-mentioned inorganic glass is reinforced so that the progress of a crack in the inorganic glass and the rupture of the inorganic glass may be prevented and which is excellent in flexibility can be obtained. In addition, even if the inorganic glass raptures in the transparent substrate, the resin layer hardly ruptures, and hence the scattering of the inorganic glass is prevented by the resin layer and the shape of the transparent substrate is maintained. Accordingly, the contamination of facilities in production steps for display devices and solar cells can be prevented, and an improvement in yield can be achieved.

The resin in the above-mentioned resin layer has a glass transition temperature of preferably 150°C to 350°C, more preferably 180°C to 320°C, and particularly preferably 210°C to 290°C. A transparent substrate excellent in heat resistance can be obtained as long as the glass transition temperature of the resin in the above-mentioned resin layer falls within such range.

The above-mentioned resin layer preferably has a light transmittance at a wavelength of 550 nm of 80% or more. The above-mentioned resin layer preferably has a refractive index at a wavelength of 550 nm of 1.3 to 1.7.

Any appropriate resin can be adopted as a material of which the above-mentioned resin layer is formed as long as an effect of the present invention is obtained. Examples of the above-mentioned resin include a thermoplastic

resin and a curable resin that cures with heat or an active energy ray. The above-mentioned resin is preferably a thermoplastic resin. Examples of the above-mentioned resin include a polyether sulfone-based resin; a polycarbonate-based resin; an epoxy-based resin; an acrylic resin; polyester-based resins such as a polyethylene terephthalate and polyethylene naphthalate; a polyolefin-based resin; cycloolefin-based resins such as a norbornene-based resin; a polyimide-based resin; a polyamide-based resin; a polyimideamide-based resin; a polyarylate-based resin; a polysulfone-based resin; and a polyether imide-based resin.

The above-mentioned resin layer preferably contains a thermoplastic resin (A) having repeating units represented by the following general formula (1) and/or the following general formula (2). The incorporation of the thermoplastic resin (A) can provide a resin layer excellent in adhesiveness with the above-mentioned inorganic glass, coupling agent layer, or adhesion layer and toughness. As a result, a transparent substrate in which a crack hardly progresses at the time of cutting can be obtained. In addition, fluctuations in dimensions of the thermoplastic resin (A) excellent in adhesiveness with the inorganic glass, coupling agent layer, or adhesion layer as described above are small because the thermoplastic resin is strongly restrained by the inorganic glass. As a result, the transparent substrate including the resin layer containing the thermoplastic resin (A) shows excellent dimensional stability.

[Chem 1]

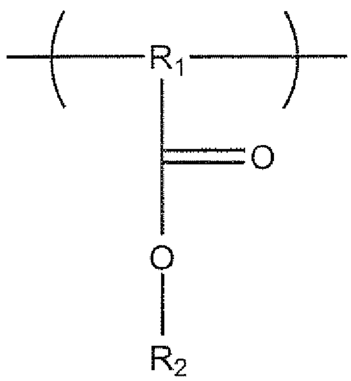

・・・ (1)

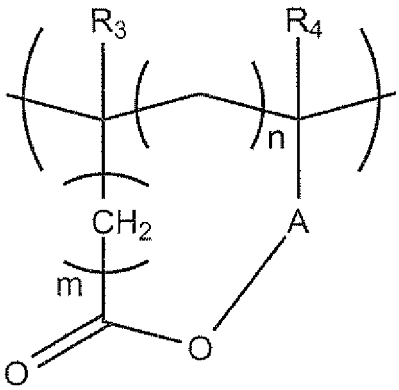

・・・ (2)

In the formula (1) : $R_1$ represents a substituted or unsubstituted aromatic hydrocarbon group having 6 to 24 carbon atoms, an alicyclic hydrocarbon group having 4 to 14 carbon atoms, or a linear or branched aliphatic hydrocarbon group having 1 to 8 carbon atoms, preferably a substituted or unsubstituted aromatic hydrocarbon group having 6 to 20 carbon atoms, an alicyclic hydrocarbon group having 4 to 12 carbon atoms, or a linear or branched aliphatic hydrocarbon group having 1 to 6 carbon atoms, and more preferably a substituted or unsubstituted aromatic hydrocarbon group having 6 to 18 carbon atoms, an alicyclic hydrocarbon group having 5 to 10 carbon atoms, or a linear or branched aliphatic hydrocarbon group having 1 to 4 carbon atoms; and $R_2$ represents a substituted or unsubstituted aromatic hydrocarbon group having 6 to 24 carbon atoms, a linear or branched aliphatic hydrocarbon group having 1 to 8 carbon atoms, an

alicyclic hydrocarbon group having 5 to 12 carbon atoms, or a hydrogen atom, and preferably a substituted or unsubstituted aromatic hydrocarbon group having 6 to 20 carbon atoms, a linear or branched aliphatic hydrocarbon group having 1 to 6 carbon atoms, an alicyclic hydrocarbon group having 5 to 10 carbon atoms, or a hydrogen atom. In the formula (2): $R_3$ and $R_4$ each independently represent a linear or branched aliphatic hydrocarbon group having 1 to 8 carbon atoms, a hydrogen atom, or an alicyclic hydrocarbon group having 5 to 12 carbon atoms, preferably a linear or branched aliphatic hydrocarbon group having 1 to 5 carbon atoms, a hydrogen atom, or an alicyclic hydrocarbon group having 5 to 10 carbon atoms, and more preferably a linear or branched aliphatic hydrocarbon group having 1 to 4 carbon atoms, a hydrogen atom, or an alicyclic hydrocarbon group having 5 to 8 carbon atoms; A represents a carbonyl group or a linear or branched aliphatic hydrocarbon group having 1 to 8 carbon atoms, preferably a carbonyl group or a linear or branched aliphatic hydrocarbon group having 1 to 6 carbon atoms, and more preferably a carbonyl group or a linear or branched aliphatic hydrocarbon group having 1 to 4 carbon atoms; m represents an integer of 0 to 8, preferably an integer of 0 to 6, and more preferably an integer of 0 to 3; and n represents an integer of 0 to 4, and preferably an integer of 0 to 2.

The above-mentioned thermoplastic resin (A) has a polymerization degree of preferably 10 to 6000, more preferably 20 to 5000, and particularly preferably 50 to 4000.

Specific examples of the above-mentioned thermoplastic resin (A) include styrene-maleic anhydride copolymers and ester group-containing cycloolefin polymers. One kind of those thermoplastic resins may be used alone, or two or more kinds of them may be used as a mixture.

The above-mentioned resin layer preferably contains a thermoplastic resin (B) having one or more repeating units represented by the following general formula (3). The incorporation of the thermoplastic resin (B) can provide a resin layer excellent in adhesiveness with the above-mentioned inorganic glass, coupling agent layer, or adhesion layer and toughness. As a result, a transparent substrate in which a crack hardly progresses at the time of cutting can be obtained. In addition, fluctuations in dimensions of the thermoplastic resin (B) excellent in adhesiveness with the inorganic glass, coupling agent layer, or adhesion layer as described above are small because the thermoplastic resin is strongly restrained by the inorganic glass. As a result, the transparent substrate including the resin layer containing the thermoplastic resin (B) shows excellent dimensional stability.

[Chem 2]

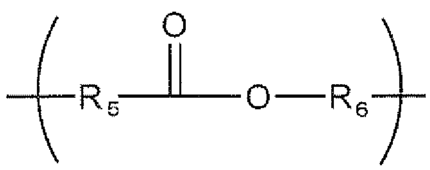

· · · (3)

In the formula (3): $R_5$ represents a substituted or unsubstituted aromatic hydrocarbon group having 6 to 24 carbon atoms, a linear or branched aliphatic hydrocarbon group having 1 to 8 carbon atoms, an alicyclic hydrocarbon group having 4 to 14 carbon atoms, or an oxygen atom, preferably a substituted or unsubstituted aromatic hydrocarbon group having 6 to 20 carbon atoms, a linear or branched aliphatic hydrocarbon group having 1 to 6 carbon atoms, an alicyclic hydrocarbon group having 4 to 12 carbon atoms, or an oxygen atom, and more preferably a substituted or unsubstituted aromatic hydrocarbon group having 6 to 18 carbon atoms, a linear or branched aliphatic hydrocarbon group having 1 to 4 carbon atoms, an alicyclic hydrocarbon group having 5 to 10 carbon atoms, or an oxygen atom; and $R_6$ represents a substituted or unsubstituted aromatic hydrocarbon group having 6 to 24 carbon atoms, a linear or branched aliphatic hydrocarbon group having 1 to 8 carbon atoms, an alicyclic hydrocarbon group having 5 to 12 carbon atoms, or a hydrogen atom, preferably a substituted or unsubstituted aromatic hydrocarbon group having 6 to 20 carbon atoms, a linear or branched aliphatic hydrocarbon group having 1 to 6 carbon atoms, an alicyclic hydrocarbon group having 5 to 10 carbon atoms, or a hydrogen atom.

The above-mentioned thermoplastic resin (B) has a polymerization degree of preferably 10 to 6000, more preferably 20 to 5000, and particularly preferably 50 to 4000.

Specific examples of the above-mentioned thermoplastic resin (B) include polyarylate, polyester, and polycarbonate. One kind of those thermoplastic resins may be used alone, or two or more kinds of them may be used as a mixture.

The above-mentioned resin layer preferably has a thermoplastic resin (C) having a hydroxyl group at any one of its terminals. The thermoplastic resin (C) is suitably used when the transparent substrate includes a coupling agent

layer formed of an epoxy group-terminated coupling agent. Specific examples of the thermoplastic resin (C) include thermoplastic resins obtained by modifying the terminals of polyimide, polyimideamide, polyether sulfone, polyether imide, polysulfone, polyarylate, and a polycarbonate with hydroxyl groups. One kind of those thermoplastic resins may be used alone, or two or more kinds of them may be used as a mixture. The use of any such thermoplastic resin can provide a resin layer excellent in adhesiveness with the coupling agent layer formed of the epoxy group-terminated coupling agent and toughness. As a result, a transparent substrate in which a crack hardly progresses at the time of cutting can be obtained. In addition, fluctuations in dimensions of the thermoplastic resin (C) excellent in adhesiveness with the coupling agent layer formed of the epoxy group-terminated coupling agent as described above are small because the thermoplastic resin is strongly restrained by the inorganic glass. As a result, the transparent substrate including the resin layer containing the thermoplastic resin (C) shows excellent dimensional stability. It should be noted that any appropriate method can be employed for the above-mentioned modification of the terminals with hydroxyl groups . In addition, details about the epoxy group-terminated coupling agent are described later.

The above-mentioned thermoplastic resin (C) has a polymerization degree of preferably 90 to 6200, more preferably 130 to 4900, and particularly preferably 150 to 3700.

In terms of polyethyleneoxide conversion, the weight-average molecular weight of the above-mentioned thermoplastic resin (C) is preferably $2.0\times10^4$ to $150\times10^4$, more preferably $3\times10^4$ to $120\times10^4$, and particularly preferably $3.5\times10^4$ to $90\times10^4$. In the case where the weight-average molecular weight of the above-mentioned thermoplastic resin (C) is less than $2.0\times10^4$, the toughness of the above-mentioned resin layer becomes insufficient and the effect of the support of the inorganic glass may become insufficient. In the case where the weight-average molecular weight of the thermoplastic resin (C) is more than $150\times10^4$, the viscosity of a solution of a resin for forming the above-mentioned resin layer becomes too high and therefore may become difficult to handle.

The above-mentioned hydroxyl group is preferably a phenolic hydroxyl group. As long as the thermoplastic resin (C) has a phenolic hydroxyl group, the above-mentioned resin layer and the coupling agent layer formed of the epoxy group-terminated coupling agent can be caused to adhere to each other strongly.

The content of the above-mentioned hydroxyl group is preferably 0.3 or more, and more preferably 0.5 to 2.0 per a polymerization degree of the thermoplastic resin (C) of 100. As long as the content of the hydroxyl group falls within such range, a thermoplastic resin excellent in reactivity with the above-mentioned epoxy group-terminated coupling agent can be obtained.

When the above-mentioned resin layer contains the thermoplastic resin (C), the above-mentioned resin layer preferably further contains imidazoles, epoxys, and/or oxetanes. When the above-mentioned resin layer contains the imidazoles, the epoxys, and/or the oxetanes, the resin layer and the inorganic glass having the above-mentioned epoxy group-terminated coupling agent layer can be caused to adhere to each other stably, and hence the transparent substrate can be obtained in high yield. The content of the above-mentioned imidazoles, with respect to the thermoplastic resin (C), is preferably 0.5 wt% to 5 wt% and more preferably 1 wt% to 4 wt%. The content of the above-mentioned epoxys, with respect to the thermoplastic resin (C), is preferably 1 wt% to 15 wt% and more preferably 3 wt% to 10 wt%. The content of the above-mentioned oxetanes, with respect to the thermoplastic resin (C), is preferably 0.5 wt% to 10 woo and more preferably 1 wt% to 5 wt%.

Examples of the above-mentioned imidazoles include 2-methylimidazole, 2-undecylimidazole, 2-heptadecylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, epoxyimidazole adduct, 2,3-dihydro-1H-pyrrolo [1,2-a]benzimidazole, 1-dodecyl-2-methyl-3-benzylimidazolium chloride, 2-phenyl-4,5-dihydroxymethylimidazole, 2-phenyl-4-methyl-5-hydroxymethylimidazole, 1-cyanoethyl-2-undecylimidazoliumtrimellitate, 1-cyanoethyl-2-phenylimidazoliumtrimellitate, 2,4-diamino-6-[2'-methylimidazolyl-(1')]-ethyl-s-triazine, 2,4-diamino-6-[2'-undecylimidazolyl-(1')]-ethyl-s-triazine, and 2,4-diamino-6-[2'-ethyl-4'-methylimidazoyl-(1')]-ethyl-s-tria zine.

As the above-mentioned epoxys, any appropriate resin can be used as long as the resin has an epoxy group in its molecule. Examples of the above-mentioned epoxys include epoxy-based resins including bisphenol types such as a bisphenol A type, a bisphenol F type, a bisphenol S type, and a hydrogenated substance thereof; novolac types such as a phenol novolac type and a cresol novolac type; nitrogen-containing cyclic types such as a triglycidylisocyanurate type and a hydantoin type; alicyclic types; aliphatic types; aromatic types such as a naphthalene type and a biphenyl type; glycidyl types such as a glycidyl ether type, a glycidyl amine type, and a glycidyl ester type; dicyclo types such as a dicyclopentadiene type; ester types; ether ester types; and modified types thereof. One kind of these epoxy-based resins may be used alone, or two or more kinds of them may be used as a mixture. The above-mentioned epoxys are preferably a bisphenol A type epoxy-based resin, an alicyclic type epoxy-based resin, a nitrogen-containing cyclic type epoxy-based resin, or a glycidyl type epoxy-based resin.

The above-mentioned oxetanes are preferably compounds each represented by the following general formula (4), (5), or (6).

[Chem 3]

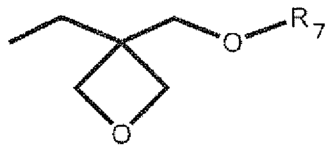

... (4)

In the above formula (4), $R_7$ represents a hydrogen atom, an alicyclic hydrocarbon group, a phenyl group, a naphthyl group, or an aliphatic hydrocarbon group having 1 to 10 carbon atoms.

[Chem 4]

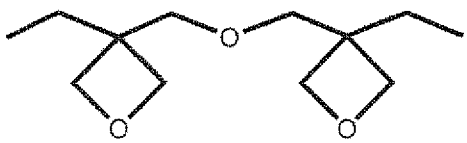

... (5)

[Chem 5]

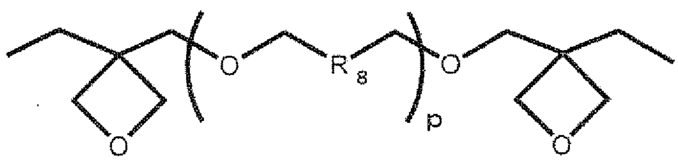

... (6)

In the above formula (6), $R_8$ represents an alicyclic hydrocarbon group, a phenyl group, a naphthyl group, or an aliphatic hydrocarbon group having 1 to 10 carbon atoms, and p represents an integer of 1 to 5.

Examples of the above-mentioned oxetanes include 3-ethyl-3-hydroxymethyloxetane (oxetane alcohol), 2-ethylhexyloxetane, xylylenebisoxetane, and 3-ethyl-3(((3-ethyloxetane-3-yl)methoxy)methyl)oxetane.

One kind of the above-mentioned thermoplastic resin (A), the above-mentioned thermoplastic resin (B), and the above-mentioned thermoplastic resin (C) may be used alone, or two or more kinds of them may be used as a mixture.

The above-mentioned resin layer may be a single layer, or may be a multilayer body. In one embodiment, the above-mentioned resin layer is a multilayer body having a layer containing the above-mentioned thermoplastic resin (A), and a layer containing a thermoplastic resin not having repeating units represented by the above general formulae (1) and (2) . In another embodiment, the above-mentioned resin layer is a multilayer body having a layer containing the above-mentioned thermoplastic resin (B) and a layer containing a thermoplastic resin not having a repeating unit represented by the above general formula (3). As long as the resin layer is any such multilayer body, a transparent substrate excellent in mechanical strength and heat resistance can be obtained.

The above-mentioned resin layer preferably has chemical resistance. To be specific, the resin layer preferably

has chemical resistance to a solvent used in, for example, a washing step or resist releasing step upon production of display devices and solar cells. Examples of the solvent used in the washing step or the like upon production of the display devices include isopropyl alcohol, acetone, dimethyl sulfoxide (DMSO), and N-methylpyrrolidone (NMP).

The above-mentioned resin layer can further contain any appropriate additive depending on purposes. Examples of the above-mentioned additive include a diluent, an antioxidant, a denaturant, a surfactant, a dye, a pigment, a discoloration preventing agent, a UV absorber, a softening agent, a stabilizer, a plasticizer, an antifoaming agent, and a stiffener. The kind, number, and amount of an additive to be contained in the above-mentioned resin layer can be set appropriately depending on purposes.

D. Coupling agent layer

The above-mentioned coupling agent layer may be formed by, for example, hardening a coupling agent on the above-mentioned inorganic glass. Examples of the above-mentioned coupling agent include an amino group-containing coupling agent, an epoxy group-containing coupling agent, an epoxy group-terminated coupling agent, an isocyanate group-containing coupling agent, a vinyl group-containing coupling agent, a mercapto group-containing coupling agent, and a (meth)acryloxy group-containing coupling agent.

When the above-mentioned resin layer contains a thermoplastic resin containing an ester bond (such as the above-mentioned thermoplastic resin (A) or thermoplastic resin (B)), an amino group-containing coupling agent, an epoxy group-containing coupling agent, or an isocyanate group-containing coupling agent is suitably used as the above-mentioned coupling agent. The substitution positions of the substituents of those coupling agents may be the terminals of the molecules, or may not be the terminals. When the resin layer containing the thermoplastic resin having an ester bond and the above-mentioned inorganic glass are placed only through a coupling agent layer formed of any such coupling agent (that is, without through any adhesion layer), the resin layer containing the thermoplastic resin having an ester bond can strongly adhere to the above-mentioned inorganic glass through the coupling agent layer. It should be noted that an amino group, epoxy group, or isocyanate group in the coupling agent is assumed to be chemically bonded to, or to interact with, the above-mentioned resin layer, and a silyl group in the coupling agent can be chemically bonded to a substituent (such as a hydroxyl group) of the above-mentioned inorganic glass. Probably as a result of the foregoing, such strong adhesiveness as described above is obtained.

When the above-mentioned resin layer contains a thermoplastic resin having a hydroxyl group (such as the above-mentioned thermoplastic resin (C)), an epoxy group-terminated coupling agent is suitably used as the above-mentioned coupling agent. When the resin layer containing the thermoplastic resin having a hydroxyl group and the above-mentioned inorganic glass are placed only through a coupling agent layer formed of any such coupling agent (that is, without through any adhesion layer), the resin layer containing the thermoplastic resin having a hydroxyl group can strongly adhere to the above-mentioned inorganic glass through the coupling agent layer. It should be noted that an epoxy group in the coupling agent is assumed to be chemically bonded to, or to interact with, the above-mentioned resin layer, and a silyl group in the coupling agent can be chemically bonded to a substituent (such as a hydroxyl group) of the above-mentioned inorganic glass. Probably as a result of the foregoing, such strong adhesiveness as described above is obtained.

The above-mentioned amino group-containing coupling agent is preferably an alkoxy silane having an amino group or a halogenated silane having an amino group, and particularly preferably an alkoxy silane having an amino group.

Specific examples of the above-mentioned alkoxy silane having an amino group include 3-aminopropyltrimethoxysilane, 3-aminopropylmethyldimethoxysilane, 3-aminopropyldimethylmethoxysilane, 3-aminopropyltriethoxy silane, 3-aminopropylmethyldiethoxysilane, 3-aminopropylmethyldimethoxysilane, 6-aminohexyltrimethoxysilane, 6-aminohexyltriethoxysilane, 11-aminoundecyltrimethoxysilane, 11-aminoundecyltriethoxysilane, and 3-triethoxysilyl-N-(1,3-dimethyl-butylidene)propylamine.

Specific examples of the above-mentioned halogenated silane having an amino group include 3-aminopropyltrichlorosilane, 3-aminopropylmethyldichlorosilane, 3-aminopropyldimethylchlorosilane, 6-aminohexyltrichlorosilane, and 11-aminoundecyltrichlorosilane.

Specific examples of the above-mentioned epoxy group-containing coupling agent and the above-mentioned epoxy group-terminated coupling agent include 2-(3,4-epoxycyclohexyl)ethyltrimethoxysilane, 3-glycidoxypropyltrimethoxysilane, 3-glycidoxypropylmethyldiethoxysilane, and 3-glycidoxypropyltriethoxysilane.

Specific examples of the above-mentioned isocyanate group-containing coupling agent include 3-isocyanatepropyltriethoxysilane.

Specific examples of the above-mentioned vinyl group-containing coupling agent include vinyltrichlorosilane, vinyltris (β-methoxyethoxy)silane, vinyltriethoxysilane, vinylmethoxysilane, and γ-methacryloxypropyltrimethoxysilane.

Specific examples of the above-mentioned mercapto group-containing coupling agent include mercaptomethyldimethylethoxysilane, (mercaptomethyl)methyldiethoxysilane, γ-mercaptopropylmethyldimethoxysilane, γ-mercaptopropyltrimethoxysilane, and γ-mercaptopropyltriethoxysilane.

Specific examples of the above-mentioned (meth)acryloxy group-containing coupling agent include γ-(meth) acryloxypropyltrimethoxysilane, γ-(meth)acryloxypropyltriethoxysilane, γ-(meth)acryloxypropylmethyldimethoxysilane, and γ-(meth)acryloxypropylmethyldiethoxysilane.

The above-mentioned coupling agent may be a commercially available coupling agent. Examples of commercially available amino group-containing coupling agents include trade name "KBM-602" (N-2-(aminoethyl)-3-aminopropylmethyldimethoxysilane), trade name "KBM-603" (N-2-(aminoethyl)-3-aminopropyltrimethoxysilane), trade name "KBE-603" (N-2-(aminoethyl)-3-aminopropyltriethoxysilane), trade name "KBM-903" (3-aminopropyltrimethoxysilane), trade name "KBE-903" (3-aminopropyltriethoxysilane), trade name "KBM-573" (N-phenyl-3-aminopropyltrimethoxysilane), and trade name "KBE-9103"
(3-triethoxysilyl-N-(1,3-dimethyl-butylidene)propylamine), all of which are manufactured by Shin-Etsu Chemical Co. , Ltd. Examples of commercially available epoxy group-containing coupling agents (or epoxy group-terminated coupling agents) include trade name "KBM-303" (2-(3,4-epoxycyclohexyl)ethyltrimethoxysilane), trade name "KBM-403" (3-glycidoxypropyltrimethoxysilane), trade name "be-402" (3--glycidoxypropylmethyldiethoxysilane), and trade name "KBE-403" (3-glycidoxypropyltriethoxysilane), all of which are manufactured by Shin-Etsu Chemical Co., Ltd. Examples of commercially available isocyanate group-containing coupling agents include trade name "KBE-9007" (3-isocyanatepropyltriethoxysilane) manufactured by Shin-Etsu Chemical Co., Ltd.

The thickness of the above-mentioned coupling agent layer is preferably 0.001 μm to 10 μm and more preferably 0.001 μm to 2 μm.

E. Adhesion layer

Any appropriate resin can be adopted as a material of which the above-mentioned adhesion layer is formed. Examples of the material of which the above-mentioned adhesion layer is formed include a thermosetting resin and an active energy ray-curable resin. Specific examples of such resins include cyclic ethers, silicone-based resins, and acrylic resins each having, for example, an epoxy group, glycidyl group, or oxetanyl group, and mixtures of these resins. In addition, the above-mentioned coupling agent may be added to the above-mentioned adhesion layer. The addition of the above-mentioned coupling agent to the above-mentioned adhesion layer can improve adhesion with the inorganic glass and/or the resin layer (when the transparent substrate has the above-mentioned coupling agent layer, adhesion with the coupling agent layer and/or the resin layer).

The above-mentioned adhesion layer has a thickness of preferably 10 μm or less, more preferably 0.01 μm to 10 μm, and particularly preferably 0.1 μm to 7 μm. As long as the thickness of the above-mentioned adhesion layer falls within such range, excellent adhesiveness between the above-mentioned inorganic glass and the above-mentioned resin layer can be realized without the impairment of the flexibility of the transparent substrate.

F. Other layer

The above-mentioned transparent substrate can include any appropriate other layer on the side of the above-mentioned resin layer opposite to the above-mentioned inorganic glass as required. Examples of the above-mentioned other layer include a transparent conductive layer and a hard coat layer.

The above-mentioned transparent conductive layer can function as an electrode or an electromagnetic wave shield upon use of the above-mentioned transparent substrate as a substrate for a display device or solar cell.

A material that can be used in the abode-mentioned transparent conductive layer is, for example, a metal such as copper or silver, a metal oxide such as indium tin oxide (ITO) or indium zinc oxide (IZO), a conductive polymer such as polythiophene or polyaniline, or a composition containing a carbon nanotube.

The above-mentioned hard coat layer has a function of imparting chemical resistance, abrasion resistance, and surface smoothness to the above-mentioned transparent substrate.

Any appropriate material can be adopted as a material of which the above-mentioned hard coat layer is formed. Examples of the material of which the above-mentioned hard coat layer is formed include epoxy-based resins, acrylic resins, silicone-based resins, and mixtures of these resins. Of those, the epoxy-based resins each of which is excellent in heat resistance are preferred. The above-mentioned hard coat layer can be obtained by curing any such resin with heat or an active energy ray.

G. Method of producing transparent substrate

A method of producing the transparent substrate of the present invention is, for example, a method involving forming the resin layer on the above-mentioned inorganic glass by solution application to provide the transparent substrate or a method involving attaching a resin film onto the above-mentioned inorganic glass through the adhesion layer to form the resin layer so that the transparent substrate may be obtained. Of those, the method involving forming the resin

layer on the above-mentioned inorganic glass by the solution application to provide the transparent substrate is preferred. With such method, the resin layer formed by the solution application is directly restrained by the inorganic glass, and hence a transparent substrate additionally excellent in dimensional stability can be obtained.

The above-mentioned method involving forming the resin layer on the above-mentioned inorganic glass by the solution application to provide the transparent substrate preferably includes the steps of: applying a solution of a resin to one side, or each of both sides, of the above-mentioned inorganic glass to form an applied layer; drying the applied layer; and heat-treating the applied layer after the drying to form the above-mentioned resin layer. The resin used here is as described in the section C.

Examples of the application solvent used in the above-mentioned application step include halogen-based solvents such as methylene chloride, ethylene chloride, chloroform, carbon tetrachloride, and trichloroethane; aromatic solvents such as toluene, benzene, and phenol; cellosolve-based solvents such as methyl cellosolve and ethyl cellosolve; ether-based solvents such as propylene glycol monomethyl ether and ethylene glycol monoisopropyl ether; and ketone-based solvents such as methyl ethyl ketone, methyl isobutyl ketone, cyclopentanone, and cyclohexanone. Of those, halogen-based solvents, aromatic solvents, cellosolve-based solvents, and ether-based solvents are preferred. When using such solvents as an application solvent, a transparent substrate having sufficiently maintained adhesiveness between the above-mentioned resin layer and the above-mentioned inorganic glass and excellent in reliable durability can be obtained even at high temperature and high humidity.

Examples of a method of applying the above-mentioned resin solution include: coating methods such as air doctor coating, blade coating, knife coating, reverse coating, transfer roll coating, gravure roll coating, kiss coating, cast coating, spray coating, slot orifice coating, calender coating, electrodeposition coating, dip coating, and die coating; and printing methods including relief printings such as flexographic printing, intaglio printings such as direct gravure printing and offset gravure printing, planographic printings such as offset printing, and stencil printings such as screen printing.

Any appropriate drying method (such as natural drying, blast drying, or heat drying) can be adopted for the above-mentioned drying step. In the case of, for example, the heat drying, a drying temperature is typically 100 to 200°C, and a drying time is typically 1 to 10 minutes.

Any appropriate heat treatment method can be adopted for the above-mentioned heat treatment step. A heat treatment temperature is typically 100°C to 300°C, and a heat treatment time is typically 5 to 45 minutes. When the transparent substrate includes a coupling agent layer, it is possible that the coupling agent and the resin in the resin layer are chemically bonded to, or caused to interact with, each other by the heat treatment.

The method preferably includes a coupling treatment for the surface of the above-mentioned inorganic glass before the above-mentioned applying step. The formation of a coupling agent layer by the coupling treatment allows the above-mentioned resin layer to strongly adhere to the above-mentioned inorganic glass through the coupling agent layer. A coupling agent used here is as described in the section D.

Any appropriate method can be adopted as a method for the above-mentioned coupling treatment. The method is, for example, a method involving applying a solution of the above-mentioned coupling agent to the surface of the above-mentioned inorganic glass and heat-treating the resultant.

Any appropriate solvent can be used as a solvent used upon preparation of the solution of the above-mentioned coupling agent as long as the solvent does not react with the coupling agent. Examples of the solvent include: aliphatic hydrocarbon-based solvents such as hexane and hexadecane; aromatic solvents such as benzene, toluene, and xylene; halogen hydrocarbon-based solvents such as methylene chloride and 1, 1, 2-trichloroethane; ether-based solvents such as tetrahydrofuran and 1,4-dioxane; alcohol-based solvents such as methanol and propanol; ketone-based solvents such as acetone and 2-butanone; and water.

Any appropriate heat treatment method can be adopted as a method for the heat treatment at the time of the abode-mentioned coupling treatment. A heat treatment temperature is typically 50°C to 150°C, and a heat treatment time is typically 1 minute to 10 minutes. As a result of the heat treatment, the coupling agent and the surface of the above-mentioned inorganic glass can be bonded to each other with a chemical bond.

In the method involving attaching the resin film onto the above-mentioned inorganic glass to form the resin layer so that the transparent substrate may be obtained, the resin layer may be formed by: applying a solution of a resin to any appropriate base material to form the resin film; and transferring the resin film onto the surface of the above-mentioned inorganic glass to attach the inorganic glass and the resin film. Alternatively, the above-mentioned inorganic glass may be subjected to a coupling treatment before the attachment of the above-mentioned resin film. The above-mentioned method can be adopted as a method for the coupling treatment.

The above-mentioned resin film may be subjected to an annealing treatment before or after its attachment to the above-mentioned inorganic glass. Impurities such as a residual solvent and an unreactedmonomer component can be efficiently removed by performing the annealing treatment. A temperature for the above-mentioned annealing treatment is preferably 100°C to 200°C, and a treatment time for the above-mentioned annealing treatment is preferably 5 minutes to 20 minutes.

The above-mentioned resin film is preferably attached to the surface of the inorganic glass through the adhesion

layer. The above-mentioned adhesion layer may be attached to the surface of the inorganic glass after having been formed on the resin film, or the resin film may be attached after the adhesion layer has been formed on the inorganic glass.

A method of forming the above-mentioned adhesion layer is, for example, a method involving: applying a thermosetting resin or active energy ray-curable resin to the surface of the above-mentioned inorganic glass or resin film; attaching the inorganic glass and the resin film after the application; and curing the thermosetting resin or active energy ray-curable resin by UV irradiation or a heat treatment after the attachment. Typical conditions for the above-mentioned UV irradiation are as described below. An irradiation cumulative light quantity is 100 $mJ/cm^2$ to 2000 $mJ/cm^2$, and an irradiation time is 5 minutes to 30 minutes. Typical conditions for the above-mentioned heat treatment are as described below. A heating temperature is 100°C to 200°C, and a heating time is 5 minutes to 30 minutes. It should be noted that the thermosetting resin or the active energy ray-curable resin may be semi-cured after the application of the thermosetting resin or the active energy ray-curable resin to the surface of the above-mentioned inorganic glass or resin film and before the attachment of the inorganic glass and the resin film. The semi-curing can be performed by, for example, applying UV light at 1 $mJ/cm^2$ to 10 $mJ/cm^2$ for 1 second to 60 seconds.

## E. Use

The transparent substrate of the present invention can be suitably used for display devices or solar cells. Examples of the display devices include a liquid crystal display, a plasma display, and an organic EL display.

## Examples

Hereinafter, the present invention is described specifically by way of examples. However, the present invention is not limited to those examples. It should be noted that a thickness was measured using a digital micrometer "KC-351C type" manufactured by Anritsu Corporation.

### Example 1

A casting solution (A) was obtained by mixing a polyarylate (U-Polymer U-100 manufactured by Unitika Limited), trichloroethane, and a leveling agent (BYK-302 manufactured by BYK-Chemie) at a weight ratio (polyarylate:trichloroethane:leveling agent) of 15:85:0.01.

Separately, one surface of an inorganic glass measuring 50 μm thick by 10 cm long by 4 cm wide (D263 manufactured by SCHOTT AG) was washed with methyl ethyl ketone, and was then subjected to a corona treatment. Subsequently, an amino group-containing coupling agent (KBM-603 manufactured by Shin-Etsu Chemical Co., Ltd.) was applied to the surface, and was then heat-treated at 110°C for 5 minutes. The above-mentioned casting solution (A) was applied to the surface of the above-mentioned inorganic glass thus subjected to the coupling treatment, and was then dried at 160°C for 10 minutes. After that, the dried product was heat-treated at 200°C for 30 minutes. Thus, a resin layer having a thickness of 25 μm was obtained. The other surface of the inorganic glass was similarly treated. Thus, a transparent substrate having a total thickness of 100 μm was obtained.

It should be noted that the resin layers formed on both surfaces of the inorganic glass each measured 10 cm long by 3 cm wide and a portion of the above-mentioned inorganic glass measuring 10 cm long by 1 cm wide was exposed.

### Example 2

A transparent substrate having a total thickness of 130 μm was obtained in the same manner as in Example 1 except that the thickness of each resin layer was set to 40 μm.

### Example 3

A transparent substrate having a total thickness of 150μ m was obtained in the same manner as in Example 1 except that the thickness of each resin layer was set to 50 μm.

### Example 4

A solution of terephthaloyl chloride (19.29 g, 0.095 mol) and isophthaloyl chloride (1.02 g, 0.005 mol) in 60 mL of methyl ethyl ketone was added to a stirred mixture of 4,4'-hexafluoroisopropylidene diphenol (23.53 g, 0.07 mol), 4,4'-(2-norbornylidene)bisphenol (8.4 g, 0.03 mol), and triethylamine (22.3 g, 0.22 mol) in 100 mL of methyl ethyl ketone at 10°C. After the addition, the temperature of the solution was increased to room temperature, and then the solution was stirred for 4 hours under nitrogen. During the stirring, triethylamine hydrochloride precipitated in a gelatin form, and

as a result, the solution started to have viscosity. After that, the solution was diluted with 160 mL of toluene. The solution was washed with diluted hydrochloric acid (200 mL of a 2% acid), and was then washed with 200 mL of water three times. After that, the solution was mightily stirred and poured into ethanol so that a bead-like resin was precipitated. The resin was collected and dried at 50°C. The glass transition temperature of the resin measured by differential scanning calorimetry was 270°C.
A casting solution (B) was obtained by mixing the resultant resin, cyclopentanone, and a leveling agent (BYK-302 manufactured by BYK-Chemie) at a weight ratio (resin:cyclopentanone:leveling agent) of 10:90:0.01.
Separately, one surface of an inorganic glass measuring 50 μm thick by 10 cm long by 4 cm wide (D263 manufactured by SCHOTT AG) was washed with methyl ethyl ketone, and was then subjected to a corona treatment. Subsequently, an amino group-containing coupling agent (KBM-603 manufactured by Shin-Etsu Chemical Co., Ltd.) was applied to the surface, and was then heat-treated at 110°C for 5 minutes. The above-mentioned casting solution (B) was applied to the surface of the above-mentioned inorganic glass thus subjected to the coupling treatment, and was then dried at 160°C for 10 minutes. After that, the dried product was heat-treated at 200°C for 30 minutes. Thus, a resin layer having a thickness of 50 μm was obtained. The other surface of the inorganic glass was similarly treated. Thus, a transparent substrate having a total thickness of 150 μm was obtained.
It should be noted that the resin layers formed on both surfaces of the inorganic glass each measured 10 cm long by 3 cm wide and a portion of the above-mentioned inorganic glass measuring 10 cm long by 1 cm wide was exposed.

Example 5

A casting solution (C) was obtained by mixing a polyether sulfone a terminal of which had been modified with a hydroxyl group (Sumika Excel 5003P manufactured by Sumitomo Chemical Company, Limited), cyclopentanone, dimethyl sulfoxide, and a leveling agent (BYK-307 manufactured by BYK-Chemie) at a weight ratio (polyether sulfone: cyclopentanone:dimethyl sulfoxide:leveling agent) of 140:658:42:0.105.
Separately, one surface of an inorganic glass measuring 50 μm thick by 10 cm long by 4 cm wide (D263 manufactured by SCHOTT AG) was washed with methyl ethyl ketone, and was then subjected to a corona treatment. Subsequently, an epoxy group-terminated coupling agent (KBM-403 manufactured by Shin-Etsu Chemical Co., Ltd.) was applied to the surface, and was then heat-treated at 110°C for 5 minutes. The above-mentioned casting solution (C) was applied to the surface of the above-mentioned inorganic glass thus subjected to the coupling treatment, and was then dried at 160°C for 10 minutes. After that, the dried product was heat-treated at 2000°C for 30 minutes. Thus, a resin layer having a thickness of 35 μm was obtained. The other surface of the inorganic glass was similarly treated. Thus, a transparent substrate having a total thickness of 120 μm was obtained.
It should be noted that the resin layers formed on both surfaces of the inorganic glass each measured 10 cm long by 3 cm wide and a portion of the above-mentioned inorganic glass measuring 10 cm long by 1 cm wide was exposed.

Example 6

A transparent substrate having a total thickness of 150 μm was obtained in the same manner as in Example 5 except that the thickness of each resin layer was set to 50 μm.

Example 7

A mixed solution obtained by mixing an epoxy-based resin (Celoxide 2021P manufactured by Daicel Chemical Industries Limited), an oxetane-based resin (ARON OXETANE OXT-221 manufactured by Toagosei Company, Limited), a photocationic polymerization initiator (ADEKA OPTOMER SP-170 manufactured by ADEKA CORPORATION), and methyl ethyl ketone at a weight ratio (epoxy-based resin:oxetane-based resin:photocationic polymerization initiator: methyl ethyl ketone) of 90:10:3:100 was applied to a polyethylene terephthalate film having a thickness of 25 μm (Lumirror T60 manufactured by Toray Industries, Inc.). After that, the solution was dried at 40°C for 1 minute. Thus, an adhesion layer having a thickness of 5 μm was formed on the above-mentioned polyethylene terephthalate film.
Separately, one surface of an inorganic glass measuring 50 μm thick by 10 cm long by 4 cm wide (D263 manufactured by SCHOTT AG) was washed with methyl ethyl ketone, and was then subjected to a corona treatment. Subsequently, an epoxy group-terminated coupling agent (KBM-403 manufactured by Shin-Etsu Chemical Co., Ltd.) was applied to the surface, and was then heat-treated at 110°C for 5 minutes . The above-mentioned polyethylene terephthalate film was attached to the surface of the above-mentioned inorganic glass thus subjected to the coupling treatment from the side of the adhesion layer, and then UV light was applied (400 mJ/$cm^2$ or more) to cure the adhesion layer. Further, the cured layer was heat-treated at 150°C for 15 minutes. The other surface of the inorganic glass was similarly treated. Thus, a transparent substrate having a total thickness of 110 μm was obtained.
It should be noted that the resin layers (polyethylene terephthalate layer) formed on both surfaces of the inorganic glass

each measured 10 cm long by 3 cm wide and a portion of the above-mentioned inorganic glass measuring 10 cm long by 1 cm wide was exposed.

Example 8

First, 10 g of diisopropyl fumarate were taken in a glass ampoule, and then 0.1 g of azobisisobutyronitrile was added as a radical polymerization initiator. Next, the inside of the ampoule was repeatedly replaced with nitrogen and deaerated, and was then hermetically sealed so that bulk polymerization was performed at 40°C for 48 hours. After the polymerization, the resultant content was dissolved in benzene, and then the solution was charged into a large amount of methanol so that a polymer was precipitated. Next, the precipitate was separated by filtration and sufficiently washed with methanol. After that, the washed product was dried under reduced pressure. Thus, a poly(diisopropyl fumarate) having a weight-average molecular weight of 235,000 was obtained.
After that, a casting solution (D) was obtained by mixing the poly(diisopropyl fumarate) and toluene at a weight ratio (poly(diisopropyl fumarate):toluene) of 1:9.
Separately, one surface of an inorganic glass measuring 50 μm thick by 10 cm long by 4 cm wide (D263 manufactured by SCHOTT AG) was washed with methyl ethyl ketone, and was then subjected to a corona treatment. Subsequently, an amino group-containing coupling agent (KBM-603 manufactured by Shin-Etsu Chemical Co., Ltd.) was applied to the surface, and was then heat-treated at 110°C for 5 minutes. The above-mentioned casting solution (D) was applied to the surface of the above-mentioned inorganic glass thus subjected to the coupling treatment, and was then dried at 100°C for 15 minutes. After that, the dried product was heat-treated at 150 °C for 10 minutes and 200°C for 20 minutes. Thus, a resin layer having a thickness of 45 μm was obtained. The other surface of the inorganic glass was similarly treated. Thus, a transparent substrate having a total thickness of 140 μm was obtained.
It should be noted that the resin layers formed on both surfaces of the inorganic glass each measured 10 cm long by 3 cm wide and a portion of the above-mentioned inorganic glass measuring 10 cm long by 1 cm wide was exposed.

Example 9

A casting solution (E) was obtained by mixing a polyarylate (U-Polymer U-100 manufactured by Unitika Limited), trichloroethane, and a leveling agent (BYK-302 manufactured by BYK-Chemie) at a weight ratio (polyarylate:trichloroethane:leveling agent) of 15:85:0.01.
The casting solution (E) was applied to the surface of a polyethylene terephthalate film, and was then dried at 110°C for 10 minutes. After that, the polyethylene terephthalate film was released. Thus, a resin film having a thickness of 25 μm was obtained. After that, the resultant resin film was subjected to an annealing treatment at 150°C for 10 minutes.
A mixed solution obtained by mixing an epoxy-based resin (Celoxide 2021P manufactured by Daicel Chemical Industries Limited), an oxetane-based resin (ARON OXETANE OXT-221 manufactured by Toagosei Company, Limited), a polymerization initiator (ADEKA OPTOMER SP-170 manufactured by ADEKA CORPORATION), and methyl ethyl ketone at a weight ratio (epoxy-based resin:oxetane-based resin:polymerization initiator :methyl ethyl ketone) of 90:10:3:100 was applied to the above-mentioned resin film. After that, the solution was dried at 40°C for 1 minute. Thus, the adhesion layer having a thickness of 5 μm was formed on the above-mentioned resin film.
Separately, one surface of an inorganic glass measuring 50 μm thick by 10 cm long by 4 cm wide (D263 manufactured by SCHOTT AG) was washed with methyl ethyl ketone, and was then subjected to a corona treatment. Subsequently, an epoxy group-terminated coupling agent (KBM-403 manufactured by Shin-Etsu Chemical Co., Ltd.) was applied to the surface, and was then heat-treated at 110°C for 5 minutes. The above-mentioned resin film was attached to the surface of the above-mentioned inorganic glass thus subjected to the coupling treatment from the side of the adhesion layer, and then UV light was applied (wavelength: 365 nm, intensity: 1000 mJ/$cm^2$ or more) with a high-pressure mercury lamp to cure the adhesion layer. Further, the cured layer was heat-treated at 150°C for 15 minutes. The other surface of the inorganic glass was similarly treated. Thus, a transparent substrate having a total thickness of 110 μm was obtained.
It should be noted that the resin layers (resin film) formed on both surfaces of the inorganic glass each measured 10 cm long by 3 cm wide and a portion of the above-mentioned inorganic glass measuring 10 cm long by 1 cm wide was exposed.

Example 10

A mixed solution obtained by mixing an epoxy-based resin (Celoxide 2021P manufactured by Daicel Chemical Industries Limited), an oxetane-based resin (ARON OXETANE Oxy-221 manufactured by Toagosei Company, Limited), a photocationic polymerization initiator (ADEKA OPTOMER SP-170 manufactured by ADEKA CORPORATION), and methyl ethyl ketone at a weight ratio (epoxy-based resin:oxetane-based resin:photocationic polymerization initiator: methyl ethyl ketone) of 90:10:3:100 was applied to a polyethylene naphthalate film having a thickness of 25 μm (teonex

Q51DW manufactured by Teijin Dupont Co., Ltd.). After that, the solution was dried at 40°C for 1 minute. Thus, an adhesion layer having a thickness of 5 μm was formed on the above-mentioned polyethylene naphthalate film. Next, UV light was applied (5 mJ/cm$^2$ or less) to the side of the adhesion layer on which the polyethylene naphthalate film was not formed so as to make the adhesion layer into a semi-cured state.
Separately, one surface of an inorganic glass measuring 50 μm thick by 10 cm long by 4 cm wide (D263 manufactured by SCHOTT AG) was washed with methyl ethyl ketone, and was then subjected to a corona treatment. Subsequently, an epoxy group-terminated coupling agent (KBM-403 manufactured by Shin-Etsu Chemical Co., Ltd.) was applied to the surface, and was then heat-treated at 110°C for 5 minutes. The above-mentioned polyethylene naphthalate film was attached to the surface of the above-mentioned inorganic glass thus subjected to the coupling treatment from the side of the adhesion layer, and then heat-treated at 150°C for 15 minutes to completely cure the adhesion layer. The other surface of the inorganic glass was similarly treated. Thus, a transparent substrate having a total thickness of 110 μm was obtained.
It should be noted that the resin layers (polyethylene naphthalate) formed on both surfaces of the inorganic glass each measured 10 cm long by 3 cm wide and a portion of the above-mentioned inorganic glass measuring 10 cm long by 1 cm wide was exposed.

(Comparative Example 1)

An inorganic glass measuring 50 μm thick by 10 cm long by 4 cm wide was prepared.

(Comparative Example 2)

A urethane-silica hybrid resin (Yuriano U201 manufactured by Arakawa Chemical Industries, Ltd.) in a mixed solvent of methyl ethyl ketone and isopropyl alcohol having a solid content of 30 wt% and a weight ratio (methyl ethyl ketone: isopropyl alcohol) of 2:1 was prepared and defined as a casting solution (F).
One surface of an inorganic glass measuring 50 μm thick by 10 cm long by 4 cm wide (D263 manufactured by SCHOTT AG) was washed with methyl ethyl ketone. After that, the casting solution (F) was applied to the surface, and was then dried at 90°C for 10 minutes. After that, the dried product was heat-treated at 130°C for 30 minutes so as to be cured. Thus, a resin layer having a thickness of 25 μm was obtained. The other surface of the inorganic glass was similarly treated. Thus, a laminate having a total thickness of 100 μm was obtained.
It should be noted that the resin layers formed on both surfaces of the inorganic glass each measured 10 cm long by 3 cm wide and a portion of the above-mentioned inorganic glass measuring 10 cm long by 1 cm wide was exposed.

(Comparative Example 3)

A casting solution (G) was obtained by adding 3 parts by weight of a photocationic polymerization initiator (ADEKA OPTOMER SP-170 manufactured by ADEKA CORPORATION) and 0.15 part by weight of a leveling agent (BYK-307 manufactured by BYK-Chemie) to 100 parts by weight of a mixed solution obtained by mixing an alicyclic epoxy resin (Celoxide 2021P manufactured by Daicel Chemical Industries Limited) and an alicyclic epoxy resin (EHPE3150 manufactured by Daicel Chemical Industries Limited) at a weight ratio (alicyclic epoxy resin:alicyclic epoxy resin) of 1:1.
Separately, one surface of an inorganic glass measuring 50 μm thick by 10 cm long by 4 cm wide (D263 manufactured by SCHOTT AG) was washed with methyl ethyl ketone, and was then subjected to a corona treatment. Subsequently, an epoxy group-terminated coupling agent (KBM-403 manufactured by Shin-Etsu Chemical Co., Ltd.) was applied to the surface, and was then heat-treated at 110°C for 5 minutes. The casting solution (G) was applied to the surface of the above-mentioned inorganic glass thus subj ected to the coupling treatment, and then UV light was applied (400 mJ/cm$^2$ or more) to cure the resin in the casting solution (G). Further, the cured resin was heat-treated at 150°C for 15 minutes. Thus, a resin layer having a thickness of 30 μm was obtained. The other surface of the inorganic glass was similarly treated. Thus, a laminate having a total thickness of 110 μm was obtained.
It should be noted that the resin layers formed on both surfaces of the inorganic glass each measured 10 cm long by 3 cm wide and a portion of the above-mentioned inorganic glass measuring 10 cm long by 1 cm wide was exposed.

(Comparative Example 4)

A casting solution (H) was obtained by adding 3 parts by weight of a photocationic polymerization initiator (ADEKA OPTOMER SP-170 manufactured by ADEKA CORPORATION) to 100 parts by weight of a rubber particle-dispersed epoxy resin (Kane Ace MX951 manufactured by KANEKA CORPORATION).
Separately, one surface of an inorganic glass measuring 50 μm thick by 10 cm long by 4 cm wide (D263 manufactured

by SCHOTT AG) was washed with methyl ethyl ketone, and was then subjected to a corona treatment. Subsequently, an epoxy group-terminated coupling agent (KBM-403 manufactured by Shin-Etsu Chemical Co., Ltd.) was applied to the surface, and was then heat-treated at 110°C for 5 minutes. The casting solution (H) was applied to the surface of the above-mentioned inorganic glass thus subjected to the coupling treatment, and then UV light was applied (400 mJ/$cm^2$ or more) to cure the resin in the casting solution (H). Further, the cured resin was heat-treated at 150°C for 15 minutes. Thus, a resin layer having a thickness of 45 μm was obtained. The other surface of the inorganic glass was similarly treated. Thus, a laminate having a total thickness of 140 μm was obtained.
It should be noted that the resin layers formed on both surfaces of the inorganic glass each measured 10 cm long by 3 cm wide and a portion of the above-mentioned inorganic glass measuring 10 cm long by 1 cm wide was exposed.

(Comparative Example 5)

A laminate having a total thickness of 120 μm was obtained in the same manner as in Comparative Example 3 except that resin layers each having a thickness of 35 μm were each formed with a casting solution (I) obtained by adding 10 parts by weight of glass fibers (PF E-301 manufactured by Nitto Boseki Co., Ltd.) to 100 parts by weight of the casting solution (G) instead of the casting solution (G).

(Comparative Example 6)

A laminate having a total thickness of 150 μm was obtained in the same manner as in Comparative Example 3 except that resin layers each having a thickness of 50 μm were each formed with a casting solution (J) obtained by adding 30 parts by weight of glass fibers (PF E-301 manufactured by Nitto Boseki Co., Ltd.) to 100 parts by weight of the casting solution (G) instead of the casting solution (G).

(Comparative Example 7)

A laminate having a total thickness of 120 μm was obtained in the same manner as in Comparative Example 3 except that resin layers each having a thickness of 35 μm were each formed with a casting solution (K) obtained as described below instead of the casting solution (G). First, 25 parts by weight of an alicyclic epoxy resin (Celoxide 2021P manufactured by Daicel Chemical Industries Limited), 25 parts by weight of an alicyclic epoxy resin (EHPE3150 manufactured by Daicel Chemical Industries Limited), and 50 parts by weight of an oxetane resin (OXT-221 manufactured by Toagosei Company, Limited) were mixed, and further, 3 parts by weight of a photocationic polymerization initiator (ADEKA OPTOMER Sup-170 manufactured by ADEKA CORPORATION) and 0.15 part by weight of a leveling agent (BYK-307 manufactured by BYK-Chemie) were added to the mixture. Thus, the casting solution was obtained.

(Comparative Example 8)

A laminate having a total thickness of 120 μm was obtained in the same manner as in Comparative Example 3 except that resin layers each having a thickness of 35 μm were each formed with a casting solution (L) obtained as described below instead of the casting solution (G). First, 40 parts by weight of an alicyclic epoxy resin (Celoxide 2021P manufactured by Daicel Chemical Industries Limited), 40 parts by weight of an alicyclic epoxy resin (EHPE3150 manufactured by Daicel Chemical Industries Limited), and 20 parts by weight of an oxetane resin (OXT-221 manufactured by Toagosei Company, Limited) were mixed, and further, 3 parts by weight of a photocationic polymerization initiator (ADEKA OPTOMER SP-170 manufactured by ADEKA CORPORATION) and 0.15 part by weight of a leveling agent (BYK-307 manufactured by BYK-Chemie) were added to the mixture. Thus, the casting solution was obtained.

(Comparative Example 9)

A laminate having a total thickness of 120 μm was obtained in the same manner as in Comparative Example 3 except that resin layers each having a thickness of 35 μm were each formed with a casting solution (M) obtained as described below instead of the casting solution (G). First, 40 parts by weight of an alicyclic epoxy resin (Celoxide 2021P manufactured by Daicel Chemical Industries Limited), 40 parts by weight of an alicyclic epoxy resin (EPICRON Hop7200 manufactured by DIC Co., Ltd.), and 20 parts by weight of an oxetane resin (OXT-221 manufactured by Toagosei Company, Limited) were mixed, and further, 3 parts by weight of a photocationic polymerization initiator (ADEKA OPTOMER SP-170 manufactured by ADEKA CORPORATION) and 0.15 part by weight of a leveling agent (BYK-307 manufactured by BYK-Chemie) were added to the mixture. Thus, the casting solution was obtained.

(Comparative Example 10)

A laminate having a total thickness of 75 μm was obtained in the same manner as in Example 1 except that the thickness of each resin layer was set to 12.5 μm.

(Comparative Example 11)

A laminate having a total thickness of 90 μm was obtained in the same manner as in Example 1 except that the thickness of each resin layer was set to 20 μm.

(Comparative Example 12)

A resin composition mainly containing an alicyclic epoxy resin (Celoxide 2021P manufactured by Daicel Chemical Industries Limited) and a bisphenol A-type epoxy resin (EPICOAT 828 manufactured by Japan Epoxy Resin Co. , Ltd.) (alicyclic epoxy resin:bisphenol A-type epoxy resin=50:50 (weight ratio)) was interposed between release films each subjected to a silicone treatment, and then the resultant was passed through a gap between metal rolls fixed at an interval of 50 μm. Thus, a laminate including an epoxy-based resin layer having a thickness of 30 μm was obtained. Next, UV light was applied (irradiation energy: 250 mJ/cm$^2$) with a UV irradiation apparatus (conveyor speed: 2.5 m/min) from one side of the above-mentioned laminate to semi-cure the epoxy-based resin layer so that a semi-cured layer was formed. Next, one release film was removed, and then the semi-cured layer of the above-mentioned laminate was attached to one surface of an inorganic glass measuring 50 μm thick by 10 cm long by 4 cm wide (D263 manufactured by SCHOTT AG) with a laminator. A semi-cured layer was attached to the other side of the inorganic glass as well by performing similar operations. Next, the remaining release film was removed, and then UV light was applied again (irradiation energy: 5000 mJ/cm$^2$ or more). After that, a heat treatment (130°C or more, 10 minutes or more) was performed to completely cure the semi-cured layers on both surfaces of the inorganic glass. Thus, a laminate whose resin layers each had a thickness of 30 μm and whose total thickness was 110 μm was obtained.
It should be noted that the resin layers formed on both surfaces of the inorganic glass each measured 10 cm long by 3 cm wide and a portion of the above-mentioned inorganic glass measuring 10 cm long by 1 cm wide was exposed.

(Comparative Example 13)

A laminate having a total thickness of 120 μm was obtained in the same manner as in Comparative Example 3 except that resin layers each having a thickness of 35 μm were each obtained with a casting solution (N) obtained by adding 7 parts by weight of glass fibers (microglass fineflake MTD025FYX manufactured by Nippon Sheet Glass Co., Ltd.) to 100 parts by weight of the casting solution (G) instead of the casting solution (G).

(Comparative Example 14)

A polycarbonate film having a thickness of 100 μm (PUREACE C110-100 manufactured by Teijin Chemicals Ltd.) was prepared.

(Comparative Example 15)

A polyethylene naphthalate film having a thickness of 100 μm (teonex Q65 manufactured by Teijin Dupont Co., Ltd.) was prepared.

(Comparative Example 16)

A polyether sulfone film having a thickness of 200 μm (sumilite FST manufactured by Sumitomo Bakelite Co., Ltd.) was prepared.

<Evaluation>

The transparent substrates and the laminates obtained in the foregoing were each evaluated by the following methods. Table 1 shows the results.

(1) Rupture diameter

(a) The transparent substrates obtained in the examples and the comparative examples, the inorganic glass of Comparative Example 1, and the laminates obtained in Comparative Examples 2 to 13 were prepared as samples for evaluation.

(b) A crack having a length of 5 mm or less was produced at the center of a longitudinal side end of the exposed portion of each inorganic glass.

(c) The longitudinal side of each sample for evaluation was bent, and the diameter of a circle using the longitudinal side as its circumference when the crack progressed in the exposed portion of the inorganic glass, and further, progressed by 1 cm in a region where a resin or the like was laminated (when the crack progressed by 2 cm in the inorganic glass of Comparative Example 1) was defined as a rupture diameter.

(2) Coefficient of linear expansion

Pieces each measuring 2 mm by 30 mm were cut out of the transparent substrates obtained in Examples 1, 3, 5, and 10, and the laminates or films obtained in Comparative Examples 1, 3, 7, 12, and 14 to 16. The pieces were defined as samples for evaluation.
The TMA values (μm) of each of the samples for evaluation at 30°C to 170°C were measured with a TMA/SS150C (manufactured by Seiko Instruments Inc.), and then an average coefficient of linear expansion was calculated.

Each of the resins of which the outermost layers of the transparent substrates and the laminates obtained in the examples and the comparative examples were formed was evaluated for its modulus of elasticity by the following method. In addition, each of the resins of which the outermost layers of the transparent substrates and the laminates obtained in the examples and Comparative Examples 2 to 13 were formed was evaluated for its fracture toughness value by the following method.

(3) Modulus of elasticity

A slot-shaped resin sample measuring 50 μm thick by 2 cm wide by 15 cm long was produced, and then its modulus of elasticity was measured with an AUTOGRAPH (AG-I manufactured by Shimadzu Corporation) from an elongation and a stress in the lengthwise direction of the slot-shaped resin sample. Test conditions were as described below. A chuck-to-chuck distance was set to 10 cm, and a tension speed was set to 10 mm/min.

(4) Fracture toughness value

A slot-shaped resin sample measuring 50 μm thick by 2 cm wide by 15 cm long was produced, and a crack (5 mm) was produced at an end (central portion) in the lengthwise direction of the slot. A tensile stress was applied with an AUTOGRAPH (AG-I manufactured by Shimadzu Corporation) in the lengthwise direction of the slot, and then a stress at the time of the rupture of the resin from the crack was measured. Test conditions were as described below. A chuck-to-chuck distance was set to 10 cm, and a tension speed was set to 10 mm/min. A fracture toughness value $K_{IC}$ at the time of the rupture was determined by substituting the resultant tensile stress σ at the time of the rupture, a crack length a, and a sample width b into the following equation ("Fracture Studies on Ceramics" published by UCHIDA ROKAKUHO PUBLISHING CO. , LTD., written by Akira Okada, P. 68 to 70).

[Num 1]

$$K_{IC}=\sigma(\pi a)^{1/2}F(a/b)$$

$$F(a/b)=1.12-0.231(a/b)+10.55(a/b)^2-21.72(a/b)^3+30.39(a/b)^4$$

[Table 1]

| | Thickness of inorganic glass (μm) | Thickness of resin layer (μm) | Thickness of adhesion layer (μm) | Total thickness of transparent substrate (laminate) (μm) | Modulus of elasticity (GPa) | Fracture toughness value (MPa·m$^{-1/2}$) | Rupture diameter (cm) | (Total thickness of resin layer)/(Thickness of inorganic glass) | Coefficient of linear expansion (ppm/°C) |
|---|---|---|---|---|---|---|---|---|---|
| Example 1 | 50 | 25 | - | 100 | 1.9 | 3.2 | 3.7 | 1 | 8 |
| Example 2 | 50 | 40 | - | 130 | 1.9 | 3.2 | 2.8 | 1.6 | - |
| Example 3 | 50 | 50 | - | 150 | 1.9 | 3.2 | 2.3 | 2 | 10 |
| Example 4 | 50 | 50 | - | 150 | 2.3 | 3.1 | 2.5 | 1.4 | - |
| Example 5 | 50 | 35 | - | 120 | 2.3 | 4-1 | 2.8 | 1.4 | 9 |
| Example 6 | 50 | 50 | - | 150 | 2.3 | 4.1 | 2.2 | 2 | - |
| Example 7 | 50 | 25 | 5 | 110 | 4.9 | 9.1 | 3.2 | 1 | - |
| Example 8 | 50 | 45 | - | 140 | 2 | 2.3 | 2.8 | 1.8 | - |
| Example 9 | 50 | 25 | 5 | 110 | 1.9 | 3.2 | 2.8 | 1.6 | - |
| Example 10 | 50 | 25 | 5 | 110 | 5.7 | 8.9 | 3.2 | 1 | 8 |
| Comparative Example 1 | 50 | - | - | 50 | - | - | 14.7 | 0 | 7 |
| Comparative Example 2 | 50 | 25 | - | 100 | 0.3 | 1.4 | 13. 5 | 1 | - |
| Comparative Example 3 | 50 | 30 | - | 110 | 1.9 | 0.4 | 9.3 | 1.2 | 8 |
| Comparative Example 4 | 50 | 45 | - | 140 | 1.4 | 1 | 4.25 | 1.8 | - |
| Comparative Example 5 | 50 | 35 | - | 120 | 2.5 | 0.4 | 6.5 | 1.4 | - |
| Comparative Example 6 | 50 | 50 | - | 120 | 3.5 | 0.7 | 4.8 | 1.4 | - |

(continued)

| | Thickness of inorganic glass (μm) | Thickness of resin layer (μm) | Thickness of adhesion layer (μm) | Total thickness of transparent substrate (laminate) (μm) | Modulus of elasticity (GPa) | Fracture toughness value ($MPa \cdot m^{-1/2}$) | Rupture diameter (cm) | (Total thickness of resin layer)/(Thickness of inorganic glass) | Coefficient of linear expansion (ppm/°C) |
|---|---|---|---|---|---|---|---|---|---|
| Comparative Example 7 | 50 | 35 | 35 | 120 | 2 | 0.7 | 4.5 | 1.4 | 10 |
| Comparative Example 8 | 50 | 35 | - | 120 | 2.2 | 1 | 5.6 | 1.4 | - |
| Comparative Example 9 | 50 | 35 | - | 120 | 2.1 | 0.5 | 5 | 1.4 | - |
| Comparative Example 10 | 50 | 12.5 | - | 75 | 1.9 | 3.2 | 7.7 | 0.48 | - |
| Comparative Example 11 | 50 | 20 | - | 75 | 1.9 | 3.2 | 4.2 | 0.8 | - |
| Comparative Example 12 | 50 | 30 | - | 110 | 2.1 | 1.3 | 4.2 | 1.2 | 10 |
| Comparative Example 13 | 50 | 35 | - | 120 | 3.2 | 0.8 | 4.2 | 1.4 | - |
| Comparative Example 14 | - | - | - | 100 | - | - | - | - | 70 |
| Comparative Example 15 | - | - | - | 100 | - | - | - | - | 18 |
| Comparative Example 16 | - | - | - | 200 | - | - | | - | 55 |

As is apparent from Table 1, according to the present invention, a transparent substrate having a small rupture diameter, i.e., excellent in flexibility because of the following reasons can be obtained. That is, the transparent substrate has a resin layer showing a specific modulus of elasticity and a specific fracture toughness value, and a ratio of the total thickness of the resin layer to the thickness of an inorganic glass has a specific value.

To be specific, the transparent substrate of the present invention has a much smaller rupture diameter than that of the single inorganic glass (Comparative Example 1). In addition, as is apparent from comparison between Examples 1 to 10, and Comparative Examples 2 to 9, and 12 and 13, the transparent substrate of the present invention shows an extremely small rupture diameter because the transparent substrate has a specific fracture toughness value. Further, as is apparent from comparison between Examples 1 to 10, and the laminates of Comparative Examples 10 and 11, the transparent substrate of the present invention shows an extremely small rupture diameter because a ratio of the total thickness of the resin layer to the thickness of an inorganic glass has a specific value.

In addition, as is apparent from comparison between Examples 1, 3, 5, and 10, and Comparative Examples 14 to 16, according to the present invention, a transparent substrate having a small coefficient of linear expansion, i.e., excellent in dimensional stability can be obtained as a result of configuration based on a combination of the inorganic glass and a specific resin layer.

As described above, the transparent substrate of the present invention is excellent both in flexibility that cannot be obtained with the inorganic glass alone and dimensional stability that cannot be obtained with the resin layer alone.

Industrial Applicability

The transparent substrate of the present invention can be widely used in display devices such as a liquid crystal display, an organic EL display, and a plasma display, and solar cells.

## Claims

**1.** A transparent substrate, comprising:

an inorganic glass having a thickness of 10 μm to 100 μm; and
a resin layer on one side, or each of both sides, of the inorganic glass,
wherein:

a ratio of a total thickness of the resin layer to a thickness of the inorganic glass is 0.9 to 4;
the resin layer has a modulus of elasticity at 25°C of 1.5 GPa to 10 GPa; and
the resin layer has a fracture toughness value at 25°C of 1.5 $MPa \cdot m^{1/2}$ to 10 $MPa \cdot m^{1/2}$.

**2.** A transparent substrate according to claim 1, wherein the resin layer contains a resin, and the resin has a glass transition temperature of 150°C to 350°C.

**3.** A transparent substrate according to claim 1 or 2, wherein the resin layer is obtained by applying a solution of a thermoplastic resin to a surface of the inorganic glass.

**4.** A transparent substrate according to any one of claims 1 to 3, further comprising a coupling agent layer on the inorganic glass.

**5.** A transparent substrate according to claim 4, wherein the coupling agent layer comprises a coupling agent layer obtained by curing an amino group-containing coupling agent, an epoxy group-containing coupling agent, or an isocyanate group-containing coupling agent, and the resin layer contains a thermoplastic resin containing an ester bond.

**6.** A transparent substrate according to claim 4, wherein the coupling agent layer comprises a coupling agent layer obtained by curing an epoxy group-terminated coupling agent, and the resin layer contains a thermoplastic resin having a hydroxyl group at any one of its terminals.

**7.** A transparent substrate according to any one of claims 1 to 3, wherein the inorganic glass and the resin layer are placed through an adhesion layer, and the adhesion layer has a thickness of 10 μm or less.

**8.** A transparent substrate according to any one of claims 4 to 6, wherein the coupling agent layer and the resin layer

are placed through an adhesion layer, and the adhesion layer has a thickness of 10 μm or less.

**9.** A transparent substrate according to any one of claims 1 to 8, wherein the transparent substrate has a total thickness of 150 μm or less.

**10.** A transparent substrate according to anyone of claims 1 to 9, wherein the transparent substrate is used as a substrate for a display device or solar cell.

**11.** A display device comprising the transparent substrate according to any one of claims 1 to 10.

**12.** A solar cell comprising the transparent substrate according to any one of claims 1 to 10.

Fig.1(a)

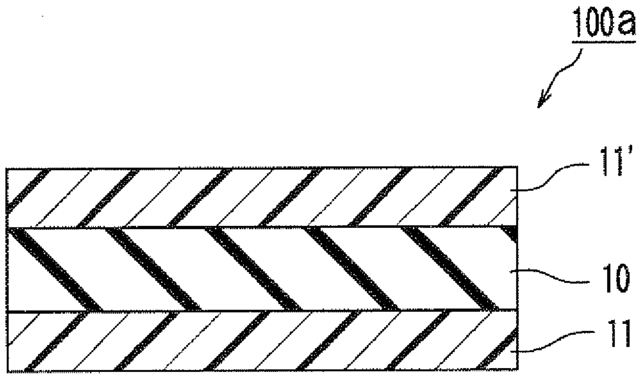


Fig.1(b)

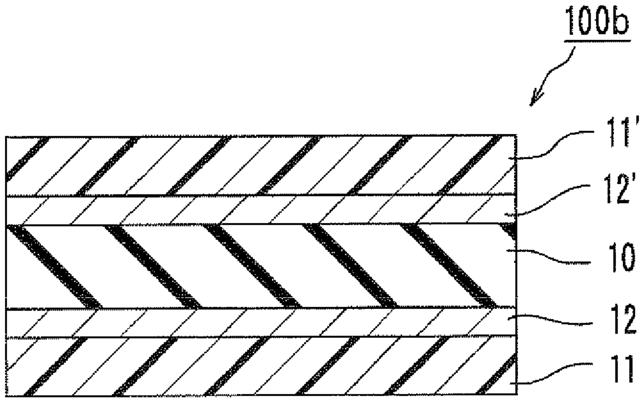

Fig.2(a)

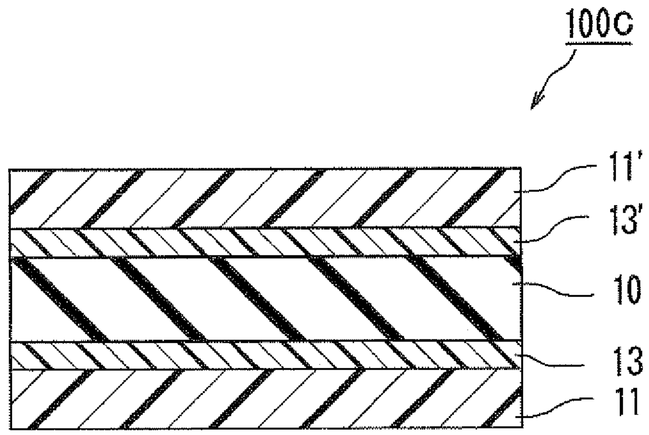


Fig.2(b)

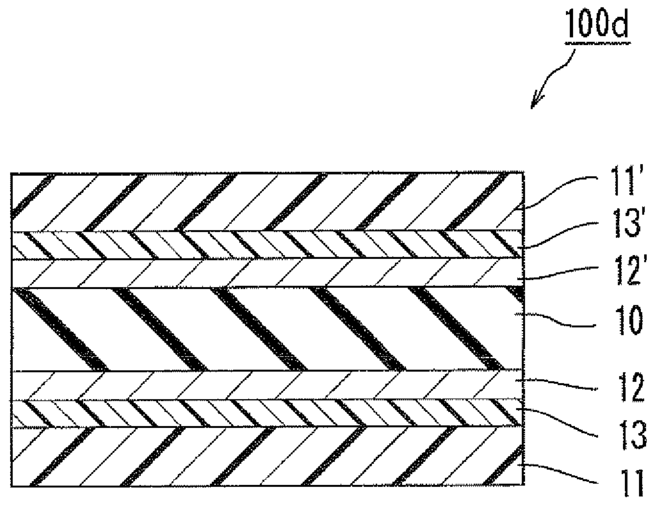

**INTERNATIONAL SEARCH REPORT**

International application No.
PCT/JP2009/057785

A. CLASSIFICATION OF SUBJECT MATTER
*G09F9/30*(2006.01)i, *B32B17/10*(2006.01)i, *G02F1/1333*(2006.01)i, *H01L51/50* (2006.01)i, *H05B33/02*(2006.01)i, *H05B33/10*(2006.01)i

According to International Patent Classification (IPC) or to both national classification and IPC

B. FIELDS SEARCHED

Minimum documentation searched (classification system followed by classification symbols)
G09F9/30, B32B17/10, G02F1/1333, H01L51/50, H05B33/02, H05B33/10

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| P,X<br>P,Y | JP 2008-107510 A (Nitto Denko Corp.),<br>08 May, 2008 (08.05.08),<br>Full text; all drawings<br>& WO 2008/050547 A1 & KR 10-2008-0069962 A<br>& CN 101356558 A | 1-4,7-11<br>5-6,12 |
| Y | JP 4-235527 A (Nitto Denko Corp.),<br>24 August, 1992 (24.08.92),<br>Full text; all drawings<br>(Family: none) | 1-12 |
| Y | JP 2003-212600 A (Panac Co., Ltd.),<br>30 July, 2003 (30.07.03),<br>Par. Nos. [0007] to [0008]<br>(Family: none) | 1-12 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 26 June, 2009 (26.06.09) | 07 July, 2009 (07.07.09) |
| Name and mailing address of the ISA/<br>Japanese Patent Office<br>Facsimile No. | Authorized officer<br><br>Telephone No. |

Form PCT/ISA/210 (second sheet) (April 2007)

**INTERNATIONAL SEARCH REPORT**

International application No.
PCT/JP2009/057785

C (Continuation). DOCUMENTS CONSIDERED TO BE RELEVANT

| Category* | Citation of document, with indication, where appropriate, of the relevant passages | Relevant to claim No. |
|---|---|---|
| Y | JP 7-205374 A (Asahi Glass Co., Ltd.), 08 August, 1995 (08.08.95), Par. Nos. [0025], [0042] & US 5569537 A & EP 636471 A1 & DE 69426906 D & ES 2156881 T | 5-6 |
| Y | JP 2007-106742 A (Tosoh Corp.), 26 April, 2007 (26.04.07), Par. Nos. [0053] to [0055] (Family: none) | 12 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 11329715 A
- JP 2008107510 A


### Non-patent literature cited in the description


- **Akira Okada.** Fracture Studies on Ceramics. UCHIDA ROKAKUHO PUBLISHING CO. , LTD, 68-70